# EUROPEAN PATENT APPLICATION

(11) **EP 1 959 489 A2**
(43) Date of publication of application: **20.08.2008**
(21) Application number: 08101582.8
(22) Date of filing: 13.02.2008
(51) Int. Cl.: H01L 21/683

(54) **Substrate support assembly**

(30) Priority: 13.02.2007 US 674669
(71) Applicant: Applied Materials, Inc., Santa Clara, CA 95054 (US)
(72) Inventor: Mahon, Christopher Richard, San Bruno, CA 94066 (US); Desai, Abhijit, Fremont, CA 94555 (US); Hirahara, Robert T., San Jose, CA 95112 (US)
(74) Representative: Zimmermann & Partner

(57) **Abstract**

A substrate support assembly (100) comprises a support block (104) having an electrode (114) and an arm to hold the support block in the process chamber, the arm (124) having a channel (164) therethrough. The arm has a first clamp (128) to attach to the support block and a second clamp (132) to attach to a chamber component. A cover lock (180) comprises an annular disc that is seated in the arm beneath the first clamp to cover and seal off electrical conductors in the channel from the chamber environment.

## Description

Embodiments of the present invention relate to a substrate support assembly for supporting a substrate in a process chamber. Specifically, they relate to a support assembly for a supporting a substrate, a method of refurbishing the substrate support assembly, a process chamber having a substrate support assembly, and a cover lock for a support assembly.

In the manufacture of electronic circuits such as, for example, integrated circuits and displays, a substrate is placed in a process chamber and a process gas is introduced into the chamber to process the substrate. The process chamber generally comprises an enclosure wall surrounding a substrate processing zone. A gas energizer can be used to energize the process gas by applying RF or microwave energy to the gas. The process gas is energized to etch features in layers on the substrate or to deposit layers on the substrate.

In the process chamber, the substrate is held on a substrate receiving surface of a substrate support. The substrate support can have an electrode that can be charged to electrostatically hold the substrate. The electrode can also be electrically charged or maintained at a ground potential to serve as a gas energizer, by an electrical connector that passes through the body of the support. Thermocouples can also be passed through the support to allow more accurate measurement of substrate temperatures. The support can also have a heater with electrical connectors to heat the substrate during processing. Thus the support typically has a plurality of electrical conductors, such as the electrical connectors, thermocouples, and other conducting structures extending therethrough to power the electrode, heater, and other devices, or to transfer sensory information.

During processing, energized halogen-containing gases and oxygen-containing gases are used to process the substrate or clean chamber surfaces. In both deposition and etch processes, fluorine-containing and chlorine-containing gases, are used to deposit or etch material from the substrate. Energized cleaning gases that contain fluorine-containing gases such as CF₄ or NF₃ are also periodically used to remove accumulated process residues from the chamber surfaces. However, the energized gases often corrode and cause failure of the substrate support assembly. For example, such gases can erode external portions of the support to cause glow discharges between the plasma and the conductors in the support. Electrical arcing can also occur when such gases erode and damage joints between electrical connectors in the support. The RF electrical potential applied to the electrode to energize the gases in the chamber can also cause glow discharges or micro-arcing which damage or "burn" connectors and adjacent portions of the support. In some plasma environments, degradation of the substrate support assembly and its conductor components can require their refurbishment or replacement after processing of only a relatively small number of substrates, which increases fabrication costs per substrate.

Thus it is desirable to have a substrate support assembly that can withstand an erosive plasma environment. It is desirable to have a substrate support that exhibits reduced electrical arcing or glow discharges. Also, it is desirable to have a substrate support that allows processing of a large number of substrates without frequent replacement or repair. It is further desirable to be able to easily refurbish or clean a substrate support and its components.
In light of the above, a support assembly according to independent claim 1, a method of refurbishing a substrate support assembly according to independent claim 12, a process chamber according to dependent claim 14,
and a cover lock according to dependent claim 16 are provided. Further advantages, features, aspects and details are evident from the dependent claims, the description and the drawings.

A support assembly for supporting a substrate in a process chamber having a process zone and chamber components is provided. The support assembly comprises a support block comprising an electrode, an arm to hold the support block in the process chamber, a plurality of electrical conductors passing through the channel of the arm, and a cover lock sized to seat in the arm. The arm has a channel therethrough, and the arm comprises a first clamp to attach to the support block and a second clamp to attach to a chamber component. The cover lock comprises an annular disc shaped and sized to seat in the arm directly beneath the first clamp, and is provided to cover and seal off the electrical conductors in the channel of the arm from the environment of the process zone.

A process chamber comprises the support assembly, and further comprises enclosure walls enclosing the support assembly, a gas distributor for providing a process gas in the process chamber, a gas energizer for energizing the process gas, and an exhaust port for exhausting the process gas.

A method of refurbishing the substrate support assembly, comprises cleaning one or more of the support block and arm by immersing the support block or arm in a cleaning solution, replacing one or more of the thermocouple and electrical ground connectors in the channel of the support arm, and replacing the silicon cover lock in the support arm about the thermocouple and electrical ground connectors.

A cover lock for a support assembly that is capable of supporting a substrate in a process chamber having a process zone and chamber components, the support assembly comprises (i) a support block comprising an electrode, (ii) an arm to hold the support block in the process chamber, the arm comprising a first clamp to attach to the support block and a second clamp to attach to a chamber component, and the arm having a channel therethrough, and (iii) a plurality of electrical conductors passing through the channel of the arm. The cover lock comprises an annular disc shaped and sized to seat in the arm directly beneath the first clamp, the annular disc comprising a perimeter, center, and a channel extending from the perimeter to the center to allow passage of the electrical conductors therethrough, and wherein the cover lock is provided to cover and seal off the electrical conductors from the environment of the process zone.

These features, aspects, and advantages of the present invention will become better understood with regard to the following description, appended claims, and accompanying drawings which illustrate examples of the invention. However, it is to be understood that each of the features can be used in the invention in general, not merely in the context of the particular drawings, and the invention includes any combination of these features, where:

FIG.1A is partial sectional schematic side view of an exemplary embodiment of a substrate processing chamber having an embodiment of a substrate support assembly;

FIG.1B is a sectional side view of a substrate support assembly having brazed electrical connections;

FIGS.2A and 2B are perspective views of the top and bottom, respectively, of a cover lock of the substrate support assembly;

FIG.3A is an exploded perspective view of the substrate support assembly of FIG. 1A, showing the cover lock and a separator ring fitting into a support arm;

FIG.3B is an exploded perspective view of the of the cover lock, locking ring and retaining plate of FIG.3A; and,

FIG.4 is a sectional view of the support arm showing a ceramic insulator between a ground connector and a thermocouple.

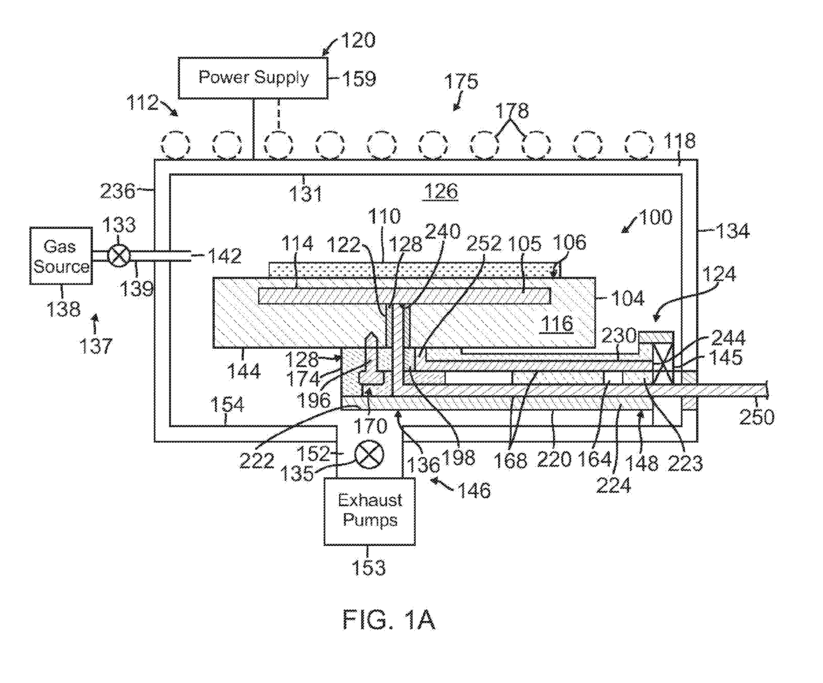

A substrate support assembly 100 comprises a support block 104 having a substrate receiving surface 106 to support a substrate 110 in a process chamber 112, as shown in FIG.1A. In the version shown, the support block 104 comprises a dielectric block 116 formed of, for example, aluminum nitride, aluminum oxide or silicon oxide. The dielectric block 116 can be a monolith or unitary structure of a dielectric material (as shown) or can be formed from a plurality of stacked plates of dielectric materials. While a version of the substrate support assembly 100 is illustrated herein, it should be understood that other versions as apparent to those of ordinary skill in the art are included within the scope of the present invention. For example, the support block 104 can also be a metal block composed of aluminum or stainless steel with a corrosion resistant coating such as anodized aluminum provided at the substrate receiving surface 106.

The support block 104 comprises an electrode 114 that is adapted to act as a part of a gas energizer 120 to energize a process gas provided in the chamber 112 to process the substrate 110. The electrode 114 may also optionally be chargeable to electrostatically hold the substrate 110 onto the substrate receiving surface 106 of the substrate support assembly 100. In one version, the electrode 114 is at least partially covered by, or embedded in a dielectric block 116. The embedded electrode 114 comprises a shape that is suitable to provide the desired electrical field characteristics across the substrate 110. For example, the embedded electrode 114 can comprise a mesh electrode or an electrode plate that is embedded in the dielectric block 116. The embedded electrode 114 is formed of a suitable conducting material, such as for example molybdenum. However, the electrode 114 can also be the support block 104 itself, for example, when the support block is a block of metal.

The support block 104 can also be adapted to control the temperature of the substrate 110. For example, the support block 104 can have heat transfer fluid conduits formed therein (not shown) to provide temperature control of a substrate 110 being supported thereon. The substrate receiving surface 106 can also have a plurality of raised mesas (not shown) that provide a more uniform distribution of heat across the substrate receiving surface 106 to control the temperature of the substrate 110.

The substrate support assembly 100 further comprises a support arm 124 that is shaped to securely hold the support block 104 in the middle of a process zone 126 in the chamber 112, and about an exhaust port 152 located in the bottom wall 154 of the process chamber 112. The support arm 124 comprises a support beam 160 that extends between the first and second ends 136, 148. The support arm 124 secures the support block 104 by providing a first clamp 128 that connects to the support block 104 and a second clamp 132 that connects to a portion of the chamber wall 134.

In the version shown, the first clamp 128 is substantially disk-shaped and comprises an inverted hollow cup 170 that is integrally connected to the arm 124. The first clamp 128 provides a flat surface that is attached to the center 140 of a lower surface 144 of the support block 104. The hollow cup 170 can serve as a protective enclosure for bolts, electrical connectors, electrical insulators and other connective or protective components of the support assembly 100.

The second clamp 132 is mounted at the second end 148 of the support arm 124 and attached to the chamber component of the chamber which can be for example, movable bellows 145 which are used to raise and lower the substrate support assembly 100 in the chamber 112, a chamber wall 134, or other chamber component. The clamps 128, 132 are connected to the support block 104 and portions of the process chamber 112 or components of the chamber by screwing, bolting, brazing, or other suitable method. The support beam 160 is composed of a material that is resistant to corrosion by energized gas to provide a secure and corrosion resistant support structure. For example, the support beam 160 can comprise a ceramic material such as at least one of aluminum nitride, aluminum oxide and silicon oxide.

The support beam 160 has a channel 164 therethrough that is sized and shaped to receive a plurality of electrical conductors 168 that can include electrical connectors such as, for example, an electrical ground connector strap 230, one or more thermocouples 250 or other electrical connectors. The channel 164 extends along at least a portion of the support arm 124 to house the conductors 168, for example, the channel 164 may extend along substantially the entire length of the support beam 160 between the two ends 136, 148. The electrical conductors 168 are routed or passed though the channel 164 to guide the conductors 168 from the support block 104 to power supplies, process monitors and other chamber components which are external to the substrate support assembly 100 or even the chamber 112. The hollow support arm 124 shields and protects the electrical conductors 168 from the energized plasma species in the chamber 112.

A brazed bond 200a,b is used to electrically join at least one of the electrical conductors 168 to other components in the support block 104. For example, an electrical conductor 168 comprising a ground connector strap 230 can be connected to the electrode 114 in the support block 104. The brazed bond 200a,b is formed by first placing a brazing compound or brazing foil between the electrical conductor 168 and the other component at the join area, then heating the join area above the melting point of the braze material and finally cooling the join area to form a brazed bond 200a,b. The brazing compound or foil can comprise one or more of gold, silver, aluminum, copper, bronze or nickel alloys and more typically comprises a nickel alloy material. The surface wetting area of the brazed bond 200a,b between the electrical conductor 168 and the electrode 114 of the support block 104 is determined in part by the diameter of the electrical connectors 168. As the diameter of the electrical conductor 168 becomes larger more brazing material is used in the brazed bond 200a,b. The additional brazed material reduces, but does not prevent, erosion of the brazed bond 200a,b by the plasma and process gases in the process zone of the chamber.

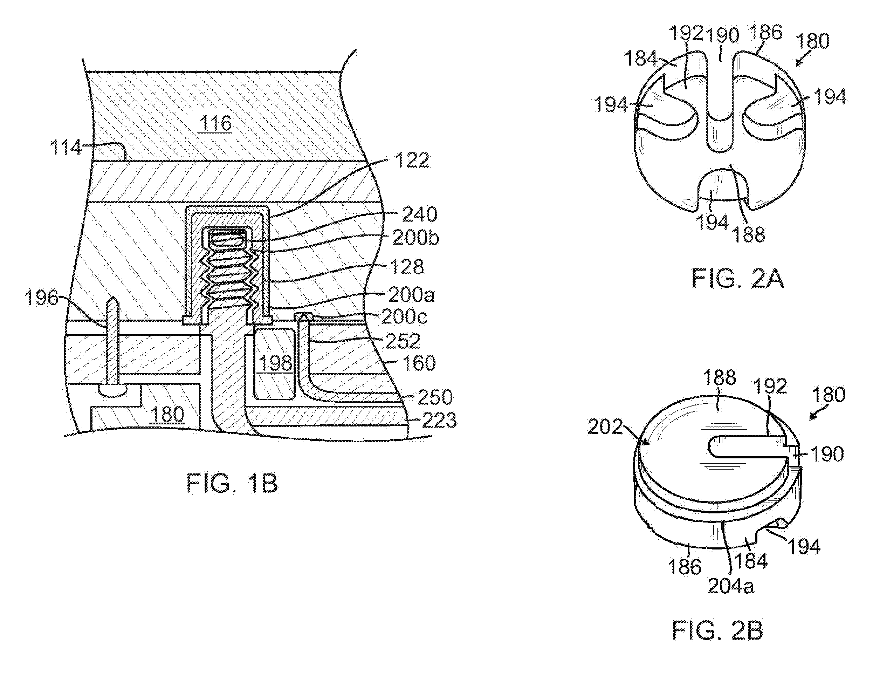

In one version, a cover lock 180 is used to further reduce the erosion problem of the brazed bonds 200a,b. The cover lock 180 is positioned inside the hollow cup 170 with surrounding walls 174 which is at the first end 136 of the support arm 124. The cup 170 and cover lock 180 form an enclosure and protect the electrical conductors 168 and the electrical connection joints from erosion in the chamber plasma environment. In the embodiment shown in FIGS.2A and 2B, the cover lock 180 comprises an annular disc 182 shaped and sized to seat in the hollow cup 170 in the first end 136 of the support arm 124. The cover lock 180 is placed directly beneath the first clamp 128 and is provided to form a barrier between the electrical conductors 168 and the chamber environment.

The annular disc 182 of the cover lock 180 comprises a perimeter 184, center 188, and a U-shaped channel extending radially from the perimeter 184 to the center 188 to allow passage of the electrical conductors 168 therethrough. The channel comprises an elongated U-shaped aperture 190 with a curved base that allows the electrical conductors 168 to rotate from a horizontal alignment in the channel 164 of the support arm 124 to a vertical alignment as they pass through the cover lock 180 to the support block 104. In one version, the U-shaped channel 188 comprises a width of from about 2mm to about 10 mm, for example, about 5mm. The diameter of the U-shaped channel 188 is sufficient to pass the electrical connectors 168 therethrough.

An upper surface 192 of the annular disc 182 of the cover lock 180 comprises a plurality of U-shaped cut-outs 194 to provide space for the heads of bolts 196 that hold the support block 104 to the support arm 124. In one version the U-shaped cut-outs 194 in the upper surface 192 of the cover lock 180 are spaced apart at an angle of 120°. The hollow cup 170 in the first end 138 also has fastener holes for the shank of bolts 196 to pass through to hold the support block 104 to the support arm 124. Each fastener hole has an inundated ledge to provide a support surface for the head of the bolt 196 and allow it to be partially countersunk. The hollow cup 170 also comprises a shaped hole for passage of the electrical conductors 168, such as an electrical ground connector strap 230 that is connected at one end to the electrodes 114 within the support block 104 and passage of a thermocouple 250 for insertion into the back side of the support block 104. The shaped hole can also accommodate a spacer 198 to separate the thermocouple 250 from the electrical ground connector strap 230.

In one version, the cover lock 180 protects the brazed joint and electrical conductors 168 from erosion by serving as a sacrificial material that reacts with and consequently depletes the concentration of the plasma species about the conductors 168. For example, the cover lock 180 can comprise silicon. The silicon material reacts with halogen-containing plasma species, such as fluorine-containing species, to form silicon fluoride gases. The fluorine-containing gasses are used in etching processes or chamber cleaning processes. Fluorine and fluorine radicals are particularly reactive to brazed bonds 200a-b that are formed with nickel-containing brazing material. Erosion of the brazing material is undesirable because the impedance of the electrical connection formed by the bond 200a,b increases with erosion of the brazing material and can even result in arcing at the damaged brazed bond 200a,b when the bond 200a,b is sufficiently chemically eroded or corroded.

The cover lock 180 can be composed of quartz, which is a crystalline form of silicon oxide, or even pure elemental silicon such as, for example, single-crystal silicon. Single-crystal silicon is optimal because of the reaction of Si with fluorine to form SiF₄, thereby depleting the fluorine left to react with the brazing material that makes up the brazed bond 200a,b.

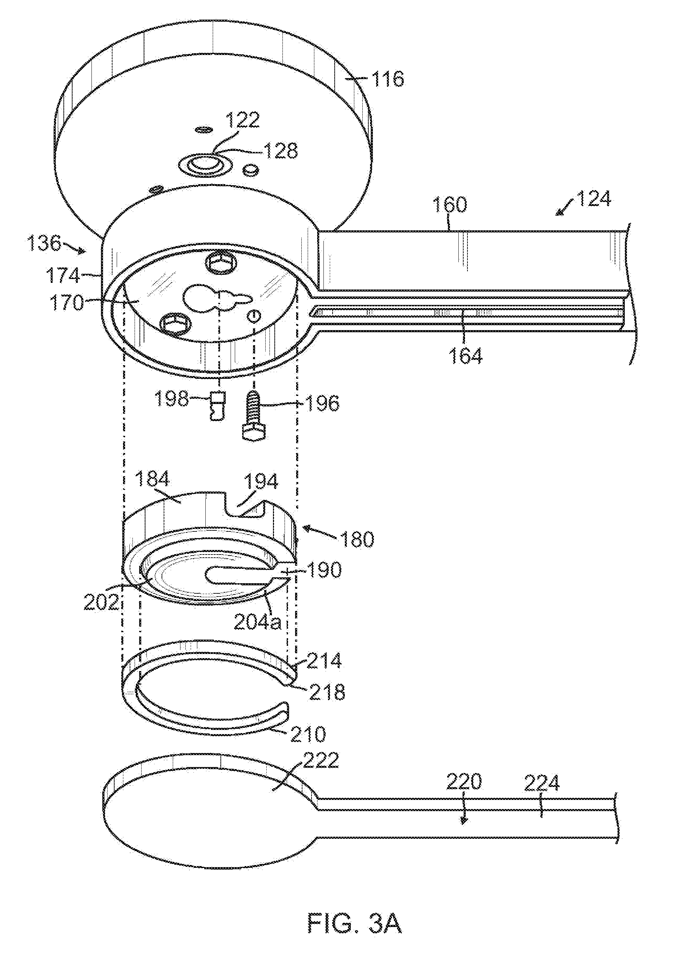

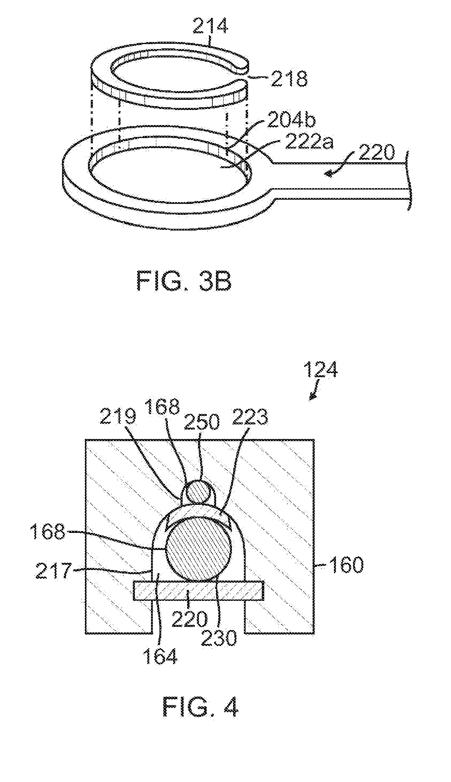

In one version, the annular disc 182 of the cover lock 180 has a bottom surface 202 with a peripheral groove 204a which is used to fit a sealing ring 210 as shown in FIG. 3A. The cover lock 180 is held in place by a lower retaining plate 220 that is shaped to fit into the cup of the first end 136 of the support arm 124 and support the back surface of the sealing ring 210. The lower retaining plate 220 comprises an annular disk portion 222 that is integrally attached to an arm portion 224. The upper surface 222a of the annular disk faces the cover lock 180 and ring 210 when the support arm is assembled. The upper surface 222a has a complimentary indentation 204b that is shaped and sized to prevent the sealing ring from sliding horizontally while in contact with the disk 222, thereby confining the sealing ring 210 to the upper surface 222a of the disk 222. In one version, as shown in FIG.3B, the indentation 204b is substantially circular.

The support arm 124 is held upside down during assembly and the various components, such as the electrical conductors 168, bolts 196 and the like are inserted into the cup 170 and attached to the support block 104. The cover lock and ring 210 are then inserted, and the retaining plate 220 is slid into the support arm 124, covering the underside of the cover lock 180 and ring 210. When the support arm 124 is turned the right way up, the sealing ring 210 drops into the indentation 204b of the lower retaining plate 220. This joins the cover lock 180 and the retaining plate 220 and prevents the retaining plate 220 from sliding out of the support arm 124 during use or installation. In one version, the sealing ring 210 comprises a C-shaped clamp 214 made from a ceramic material, such as aluminum oxide. The C-shaped clamp 214 comprises an opening 218 that is aligned with the U-shaped channel 188 in the annular disc 182. The aluminum oxide material is desirable because it is inert to the reactant gasses, fluorine radicals and plasma environment that can be present in the chamber.

In use, the support arm 124 is used to hold electrical conductors 168 such as an electrical ground connector strap 230 that is passed through the channel 164 of the hollow support arm 124. The connector strap 230 electrically grounds portions of the support block 104, such as the electrode 114, while another electrode 236, such as a wall of the chamber 112 is electrically biased so that a process gas provided in the chamber 112 can be energized to form energized gas, such as plasma. The connector strap 230 can also remove excess electrical charge from portions of the support block 104 to facilitate removal of the substrate 110 from the substrate receiving surface 106 after processing. The connector strap 230 comprises a first terminal 240 that is electrically connected to the electrode 114 (as shown) or the support block 104 itself when the support block functions as an electrode, and a second terminal 244 that is electrically connected outside the process chamber 112 to "ground" the electrode 114 or maintain the electrode 114 at about the same potential as the process chamber 112. The second terminal 244 can also be connected to a bottom wall 154 of the chamber 112. The electrical ground connector strap 230 desirably comprises an electrically conductive material, such as for example one or more of stainless steel, nickel, molybdenum, aluminum, hastelloy, and alloys thereof.

The first terminal 240 of the connector strap 230 can be electrically connected to the electrode 114 by, for example, braze joining the first terminal 240 to the electrode 114. The electrical connection can also be formed through an intermediary lug 128. A cylindrical bore 122 is machined into the bottom surface of the support block 104 and to the electrode 114. The lug 128 is then embedded into the cylindrical bore 122 and is braze-bonded to the electrode 114 and to the inner surface of the cylindrical bore 122 with a braze bond 200a. In the version shown in FIG.1B, the lug 128 is a threaded lug and the first terminal 240 comprises a threaded connector. The first terminal 240 is screwed into the threaded lug 128. The first terminal 240 is then optionally brazed to the threaded lug 128 to form a brazed bond 200b. Alternately, a threaded hole can be bored directly into the bottom surface of the support block 104 and to the electrode 114. An intermediary conductor can be brazed to the exposed portion of the electrode in order to provide a more uniform contact surface for the first terminal 240. The first terminal 240 of the connector strap 230 or other connector is screwed directly into the threaded hole of the support block 104. An electrical connection can then be formed between the electrode 114 and the first terminal 240 either through direct contact, by contact with an intermediary brazed conductor or by brazing the tip of the first terminal 240 to either the electrode 114 or intermediary brazed conductor.

The support arm 124 can also hold an electrical conductor 168 comprising a thermocouple 250 that is passed through the channel 164 of the hollow support arm 124 and also positioned near the ground connector strap 230. FIG.1A shows a substrate support assembly 100 having at least a portion of the thermocouple 250 routed through the channel 164. The thermocouple 250 is adapted to detect temperatures about the substrate support assembly 100, such as the temperature of one or more of the substrate 110 and portions of the support block 104. The thermocouple 250 generally comprises two or more dissimilar wires, such as metal wires or semi-conducting rods that are welded or otherwise joined together at their ends. Examples of suitable wires include platinum and rhodium, or chromium alloy and aluminum alloy. A difference in temperature between the two ends or junctions generates an emf having a magnitude that is related to the temperature difference between the junctions. The generated emf can be measured by a temperature monitoring system (not shown) comprising a suitable millivoltmeter or potentiometer that is connected to the circuit formed by the wires. The thermocouple 250 comprises a first terminal 252 that is connected to or placed adjacent to the support block 104 to detect the temperature of portions of the support block 104.

FIG.4 shows a schematic side view of the hollow support arm 124 illustrating an embodiment of an arrangement of the connector strap 230 and thermocouple 250 in the channel 164 of the support arm 124. In this embodiment, the connector strap 230 and thermocouple 250 are aligned parallel to each other along the long axis of the support beam 160 and are arranged relatively close to one another to minimize the amount of space required to fit the support arm 124 in the chamber 112. For example, the distance between the ground connector strap 230 and thermocouple 250 may be less than about 50 mm, such as for example from about 0.010 mm to 0.05 mm. The retaining plate 220 supports the electrical conductors 168 inside the support arm 124.

In one version, the substrate support assembly 100 further comprises a ceramic insulator 223 positioned in between the electrical ground connector strap 230 and the thermocouple 250 in the channel of the support arm 124. The ceramic insulator 223 is provided in order to reduce the occurrence of electrical arcing between the ground connector strap 230 and thermocouple 250, thereby increasing the part life of the substrate support assembly 100. The ceramic insulator may comprise one of more of aluminum nitride, aluminum oxide, zirconium oxide, silicon oxide, silicon carbide, mullite and silicon nitride. The ceramic insulator 223 also desirably comprises a thickness suitable to electrically shield the thermocouple 250 and ground connector strap 230, such as a thickness of about 0.5 cm.

To facilitate the arrangement of the ground connector strap 230 and thermocouple 250 near one another, and to reduce manufacturing costs, the channel 164 can be formed having differently sized upper and lower grooves 217, 219. In one version, the ground connector strap 230 is positioned above the thermocouple 250 in an upper groove 217 and the thermocouple 250 is positioned below the ground connector strap 230 in a lower groove 219. In the version shown in FIG.4, the ceramic insulator 223 is sized and shaped to rest on the bottom surface of the upper groove 217 between the ground connector strap 230 and thermocouple 250, and may even be partially supported by the upper surface of the underlying thermocouple 250. The ceramic insulator 223 can also be shaped to at least partially conform to the shape of the overlying ground connector strap 230. The ceramic insulator 223 can comprise a single piece of ceramic material that extends continuously along the length of the channel 164, or can be in the form of several smaller insulator strips 223.

The above-described configuration of the substrate support assembly 100 having the cover lock 180 about the ground connector strap 230 and thermocouple 250 has been discovered to provide good resistance to corrosion in the process chamber 112 by reducing the erosion rate of the brazed bonds 200 between the electrical conductors 168 and the support block 104, hence reducing the occurrence of electrical arcing between the ground connector strap 230 and the electrodes 114 of the support block 104 during processing of substrates 110 in the chamber 112. The use of the cover lock 180 also preserves the ease of assembly of the substrate support assembly 100, as the ground connector strap 230 and thermocouple 250 may be easily routed through the same channel 164. Thus, the substrate support assembly 100 having the cover lock 180 provides an improved corrosion resistant support component for the processing of substrates 110 in the process chamber 112.

The substrate support assembly 100 also allows for refurbishing of the assembly 100 to provide a longer processing lifetime. The refurbishing process may allow for the cleaning of parts such as the support block 104 and support arm 124 to remove process residues, as well as the replacement of any corroded assembly parts, such as portions of the support block 104. As the cover lock 180 inhibits electrical arcing and reduces corrosion of the ground connector strap 230, the refurbishing process may also be performed without requiring replacement of the ground connector strap 230.

To refurbish the substrate support assembly 100, one or more of the thermocouple 250 and metal plate are removed from the support block 104. A cleaning process is then performed to clean process residues from one or more of the support block 104 and support arm 124. The cleaning process can comprise, for example, immersing the support block 104 and support arm 124 in a cleaning solution comprising acidic or basic species, such as for example HF or KOH, as described for example in U.S. Application Serial No. 10/032,387, Attorney Docket No. 6770, to He et al, filed on December 21, 2001, assigned to Applied Materials, and U.S. Application Serial No. 10/304,535, Attorney Docket No. 8061, to Wang et al, filed on November 25, 2002, and assigned to Applied Materials, which are herein incorporated by reference in their entireties. The cleaning solution removes any process residues and also can remove any loose grains from the dielectric block 116 and support arm 124 which could otherwise contaminate the substrate 110 during processing. A grit blasting process can also be performed to clean and refurbish the support block 104 and support arm 124, as described in the above-referenced applications. After the cleaning process has been performed, the same or a fresh thermocouple 250 is arranged adjacent to the support block 104, for example by brazing a tip of the thermocouple to the lower surface 144 of the support block 104. The thermocouple 250 and ground connector strap 230 are re-routed through the channel of the support arm 124, and the cover lock 180 is placed therebetween.

An apparatus 102 suitable for processing a substrate 110 with the substrate support assembly 100 comprising the hollow support arm 124 with the cover lock 180 comprises a process chamber 112, as shown in FIG.1A. The particular embodiment of the apparatus 102 shown herein is suitable for processing substrates 104, such as semiconductor wafers, and may be adapted by those of ordinary skill to process other substrates 104, such as flat panel displays, polymer panels, or other electrical circuit receiving structures. The apparatus 102 is particularly useful for processing layers, such as etch resistant, silicon-containing, metal-containing, dielectric, and/or conductor layers on the substrate 110.

The apparatus 102 may be attached to a mainframe unit (not shown) that contains and provides electrical, plumbing, and other support functions for the apparatus 102 and may be part of a multichamber system (not shown). The multichamber system has the capability to transfer a substrate 110 between its chambers without breaking the vacuum and without exposing the substrate 110 to moisture or other contaminants outside the multichamber system. An advantage of the multichamber system is that different chambers in the multichamber system may be used for different purposes in the entire process. For example, one chamber may be used for etching a substrate 110, another for the deposition of a metal film, another may be used for rapid thermal processing, and yet another may be used for depositing an anti-reflective layer. The process may proceed uninterrupted within the multichamber system, thereby preventing contamination of substrates 104 that may otherwise occur when transferring substrates 104 between various separate individual chambers for different parts of a process.

Generally, the process chamber 112 comprises a wall 107, such as an enclosure wall 103, which may comprise a ceiling 118, sidewalls 115, and a bottom wall 117 which enclose a process zone 108. In operation, process gas is introduced into the chamber 112 through a gas supply 130 that includes a process gas source 138, and a gas distributor 137. The gas distributor 137 may comprise one or more conduits 139 having one or more gas flow valves 133 and one or more gas outlets 142 around a periphery of the substrate 110 which is held in the process zone 108 on the substrate support assembly 100 having the substrate receiving surface 106. Alternatively, the gas distributor 137 may comprise a showerhead gas distributor (not shown). Spent process gas and etchant byproducts are exhausted from the chamber 112 through an exhaust 146 which may include a pumping channel that receives spent process gas from the process zone via the exhaust port 152, a throttle valve 135 to control the pressure of process gas in the chamber 112, and one or more exhaust pumps 153.

The process gas may be energized to process the substrate 110 by a gas energizer 120 that couples energy to the process gas in the process zone 108 of the chamber 112. In the version shown in FIG.1A, the gas energizer 120 comprises process electrodes 105, 236, and a power supply 159 that supplies power to one or more of the electrodes 105, 236 to energize the process gas. The process electrodes 105, 236 may include an electrode 236 that is or is in a wall, such as a sidewall 115 or ceiling 118 of the chamber 112 that is capacitively coupled to another electrode 114, such as the electrode 114 in the substrate support assembly 100 below the substrate 110. In one version, the gas energizer 120 powers an electrode comprising a gas distribution plate that is part of a showerhead gas distributor in the ceiling 118 (not shown.) Alternatively or additionally, the gas energizer 120 may comprise an antenna 175 comprising one or more inductor coils 178 which may have a circular symmetry about the center of the chamber 112. In yet another version, the gas energizer 120 may comprise a microwave source and waveguide to activate the process gas by microwave energy in a remote zone upstream from the chamber 112 (not shown).

To process a substrate 110, the process chamber 112 is evacuated and maintained at a predetermined sub-atmospheric pressure. The substrate 110 is then provided on the substrate receiving surface 106 of the substrate support assembly by a substrate transport 101, such as a robot arm and a lift pin system. The gas energizer 120 then energizes a gas to provide an energized gas in the process zone 108 to process the substrate 110 by coupling RF or microwave energy to the gas. A bellows structure (not shown) can raise or lower the substrate support assembly 100 to provide the desired plasma processing characteristics.

According to some embodiments described herein, a substrate support assembly including a support block having an electrode and an arm to hold the support block in the process chamber, the arm having a channel therethrough is provided. The arm has a first clamp to attach to the support block and a second clamp to attach to a chamber component. A cover lock comprises an annular disc that is seated in the arm beneath the first clamp to cover and seal off electrical conductors in the channel from the chamber environment.

Further, embodiments of a cover lock may include one or more of the following implementations. The annular disc is composed of silicon or quartz. The cover lock includes a top surface having a plurality of U-shaped cut-outs to seat bolt heads, the cut-outs being spaced apart at angle of 120°. The annular disc includes a bottom surface with a peripheral groove, and further includes a ceramic locking ring that fits in the peripheral groove. The ceramic locking ring includes a C-shaped clamp composed of aluminum oxide.

Although exemplary embodiments of the present invention are shown and described, those of ordinary skill in the art may devise other embodiments which incorporate the present invention, and which are also within the scope of the present invention. For example, other support arm structures and shapes other than those specifically mentioned may be used. Also, the positions of the ground connector strap 230 and thermocouple 250 in the support arm 124 can be reversed, or they can be positioned side-by-side, as would be apparent to those of ordinary skill in the art. Furthermore, the terms below, above, bottom, top, up, down, first and second and other relative or positional terms are shown with respect to the exemplary embodiments in the figures and are interchangeable. Therefore, the appended claims should not be limited to the descriptions of the preferred versions, materials, or spatial arrangements described herein to illustrate the invention.

## Claims

1. A support assembly (100) for supporting a substrate in a process chamber having a process zone (126) and chamber components, the support assembly comprising:
(a) a support block (104) comprising an electrode (114);
(b) an arm (124) to hold the support block in the process chamber, the arm having a channel (164) therethrough, and the arm comprising a first clamp (128) to attach to the support block and a second clamp (132) to attach to a chamber component;
(c) a plurality of electrical conductors (168) passing through the channel of the arm; and
(d) a cover lock (180) comprising an annular disc shaped and sized to seat in the arm directly beneath the first clamp, the cover lock provided to cover and seal off the electrical conductors (168) in the channel of the arm from the environment of the process zone.

2. An assembly according to claim 1 wherein the support block comprises a dielectric block.

3. An assembly according to any of claims 1 to 2, wherein the cover lock is composed of silicon or quartz.

4. An assembly according to any of claims 1 to 3, wherein the cover lock (180) comprises a perimeter (184) and a center (188), and wherein a channel extends from the perimeter to the center to allow passage of the electrical conductors to the center.

5. An assembly according to claim 4 wherein the cover lock (180) comprises a top surface having a plurality of U-shaped cut-outs (194) to seat bolt heads.

6. An assembly according to claim 5 wherein the U-shaped cut-outs are spaced apart at an angle of about 120°.

7. An assembly according to any of claims 1 to 6, wherein the annular disc of the cover lock (180) comprises a bottom surface (202) with a peripheral groove (204a), and wherein the assembly further comprises a ceramic locking ring that fits in the peripheral groove.

8. An assembly according to claim 7 wherein the ceramic locking ring comprises a C-shaped clamp and/or wherein the ceramic locking ring comprises aluminum oxide.

9. An assembly according to any of claims 1 to 8 wherein the plurality of electrical conductors comprise (i) a thermocouple, and (ii) an electrical ground connector.

10. An assembly according to claim 9 wherein electrical ground connector comprises a first terminal to electrically connect to the electrode and a second terminal adapted to electrically ground the electrode.

11. An assembly according to claim 9 wherein the cover lock comprises an annular disc of silicon that is shaped and sized to seat in the arm (124) directly beneath the first clamp (128), and further comprises a perimeter, center, and a channel extending from the perimeter to the center of the cover lock (180) to allow passage of the electrical ground connector and the thermocouple in the arm to protect the same from the environment of the process zone (126).

12. A method of refurbishing the substrate support assembly (100) of claim 10, the method comprising:
(a) cleaning one or more of the support block (104) and arm by immersing the support block or arm in a cleaning solution;
(b) replacing one or more of the thermocouple and electrical ground connectors in the channel of the support arm (124); and
(c) replacing the silicon cover lock (180) in the support arm about the thermocouple and electrical ground connectors.

13. A method according to claim 12 wherein (a) comprises immersing one or more of the support block and arm in a solution comprising acidic or basic species.

14. A process chamber comprising the support assembly (100) of any of claims 1 to 11, the process chamber further comprising:
(a) enclosure walls enclosing the support assembly;
(b) a gas distributor for providing a process gas in the process chamber;
(c) a gas energizer for energizing the process gas; and
(d) a exhaust port for exhausting the process gas.

15. A cover lock (180) for a support assembly according to any of claims 1 to 11, the cover lock comprising:
the annular disc being shaped and sized to seat in the arm directly beneath the first clamp, the annular disc comprising a perimeter (184), center (188), and a channel extending from the perimeter to the center to allow passage of the electrical conductors (168) therethrough, and
wherein the cover lock is provided to cover and seal off the electrical conductors from the environment of the process zone (126).
